# EUROPÄISCHE PATENTSCHRIFT

(11) **EP 1 995 514 B1**
(45) Veröffentlichungstag und Bekanntmachung des Hinweises auf die Patenterteilung: **04.05.2011**
(21) Anmeldenummer: 08102984.5
(22) Anmeldetag: 27.03.2008
(51) Int. Cl.: F21V 29/00, F21V 7/00, F21V 7/20, F21Y 101/02

(54) **Beleuchtungseinheit**
Lighting unit
Unité d'éclairage

(30) Priorität: 23.05.2007 DE 102007023918
(43) Veröffentlichungstag der Anmeldung: 26.11.2008
(73) Patentinhaber: Osram Gesellschaft mit beschränkter Haftung, 81543 München (DE)
(72) Erfinder: Hellinger, Leopold, 3710, Ziersdorf (AT); Neumann, Gerhard, 3231, St. Margarethen (AT)

(56) Entgegenhaltungen:
- WO-A-2005/078338
- WO-A-2005/099323
- DE-A1- 19 917 401

## Beschreibung

Die Erfindung betrifft eine Beleuchtungseinheit mit einem flächenförmigen Trägerteil, auf dem beidseitig jeweils eine Mehrzahl von lichtemittierenden Halbleiterbauelementen, insbesondere Hochleistungs-Leuchtdioden, angeordnet sind, und auf jeder Seite des Trägerteils jeweils ein Kühlkörper vorgesehen ist.

### Stand der Technik

Es ist bekannt, dass bei Kraftfahrzeugen verschiedene Beleuchtungseinrichtungen, wie beispielsweise Blinkleuchten eingesetzt werden, bei denen sowohl in eine vordere als auch in eine rückwärtige Richtung Licht ausgestrahlt wird. Als lichtemittierende Bauelemente werden heutzutage auch Halbleiterbauelemente, insbesondere Hochleistungs-Leuchtdioden (LED) eingesetzt, wie sie beispielsweise aus der DE 101 17 889 A1 bekannt sind. Die Leistungsaufnahme dieser Hochleistungs-LED's liegt meist zwischen 1 bis 3 W oder höher, was besondere Vorkehrung zur Wärmeabfuhr erforderlich macht. Üblicherweise werden diese Hochleistungs-Leuchtdioden auf zwei getrennten Leiterplatten angeordnet. Die Bündelung der Strahlung erfolgt bei bekannten Vorrichtungen jeweils über separate Reflektoren auf der Vorderseite bzw. auf der Rückseite. Um die bei Betrieb anfallende Wärme abzuleiten, ist bekannt, zwischen den Leiterplatten einen Kühlkörper vorzusehen. Diese ist aber aufwändig und erfordert ein entsprechendes Bauvolumen.
Aus der DE 199 22 176 C2 ist eine oberflächenmontierte LED-Anordnung bekannt, bei der eine Leiterplatte mit ihrer den LED's abgewandten Seite auf einem Kühlkörper angebracht ist, wodurch die Wärmeableitung nach hinten unterstützt wird. Diese Konstruktion ermöglicht aber nur eine Abstrahlung des Lichtes in eine Richtung.

Das Dokument DE 199 17 401 A1 offenbart den Oberbegriff des Anspruchs 1.

### Darstellung der Erfindung

Aufgabe der vorliegenden Erfindung ist es, bei einer Beleuchtungseinheit, bei der eine Mehrzahl von lichtemittierenden Halbleiterbauelementen auf beiden Hauptflächen eines flächenförmigen Trägerteils angeordnet sind, auf möglichst einfache Weise eine verbesserte Wärmeableitung zu schaffen.

Diese Aufgabe wird durch eine Beleuchtungseinheit mit den Merkmalen des Patentanspruchs 1 gelöst. Vorteilhafte Weiterbildungen der Erfindung sind Gegenstand von abhängigen Ansprüchen.

Bei einer Beleuchtungseinheit mit einem flächenförmigen Trägerteil, auf dem beidseitig jeweils eine Mehrzahl von lichtemittierenden Halbleiterbauelementen, insbesondere Hochleistungs-Leuchtdioden, angeordnet sind, und bei der auf jeder Seite des Trägerteils jeweils ein Kühlkörper vorgesehen ist, ist erfindungsgemäß vorgesehen,
- dass jedes Halbleiterbauelement mittels eines Wärmeleitmittels, das durch eine Durchführung des Trägerteils hindurchgeführt ist, gut wärmeleitend mit einem, an der dem Halbleiterbauelement gegenüberliegenden Seite des Trägerteils vorgesehenen Kühlkörper verbunden ist, und
- dass an jedem der Kühlkörper zumindest ein Reflektor ausgebildet ist, der eine reflektierende Oberfläche aufweist, welche die Lichtemission eines Halbleiterbauelementes bündelt, welches auf der diesem Kühlkörper zugewandten Seite des Trägerteils angeordnet ist.

Dadurch wird von einem Bauteil sowohl die Funktion der Kühlung, als auch die Funktion der Bündelung der Lichtstrahlen erbracht. Dies vereinfacht die Konstruktion erheblich. Verglichen mit bislang bekannten Konstruktionen entfallen die Kosten für die zweite Leiterplatte und die Kosten separater Reflektoren. Die Beleuchtungseinheit benötigt insgesamt ein vergleichsweise geringes Bauvolumen und hat ein vergleichsweise geringeres Gewicht auf. Die direkte Wärmeabfuhr auf einen Kühlkörper, der auf der gegenüberliegenden Seite des Trägerteils vorgesehen ist, hat den Vorteil, dass eine vergleichsweise größere Wärmeübergangsfläche genutzt werden kann. Im Ergebnis können die Hochleistungs-Leuchtdioden mit einem höheren Strom betrieben werden, wodurch eine größere optische Leistung gezielt werden kann.
Das Trägerteil kann eine herkömmliche Leiterplatte, beispielsweise eine starre FR4 Leiterplatte oder ein ebenes Keramiksubstrat sein. Das Trägerteil kann aber auch gekrümmt durch eine flexible Leiterplatte, beispielsweise aus Polyimid, gebildet werden. Je nach Ausbildung des Trägerteils kann das zum Transport der Wärme auf die gegenüberliegende Seite des Trägerteils dienende Wärmeleitmittel unterschiedlich ausgeführt sein, zum Beispiel bei einem starren, plattenförmigen Träger durch herkömmliche Durchkontaktierung oder durch ein metallisches Einsatzteil, das in einer Durchbrechung der Trägerplatte oberflächenbündig eingesetzt ist. Für die Ausbildung der reflektierenden Oberfläche stehen verschiedene Oberflächenbehandlungsverfahren zur Verfügung, wie beispielsweise das Aufbringen einer spiegelnden Hochglanzschicht.
Es kann von Vorteil sein, wenn jedem auf einer Hauptfläche angeordneten Halbleiterbauelement jeweils ein Reflektor zugeordnet ist, der an einem, zu dieser Hauptfläche benachbart liegenden Kühlkörper ausgebildet ist.

Für eine kostengünstige Fertigung kann es günstig sein, wenn jeder Kühlkörper und jeder an diesem Kühlkörper ausgebildete Reflektor einstückig und materialeinheitlich aus einem gut wärmeleitenden Werkstoff, z.B. einem Metall hergestellt ist. Dadurch lässt sich dieses integrale Bauteil, das sowohl zur Kühlung der Halbleiterbauelemente als auch zur Lenkung des ausgestrahlten Lichts dient, in großen Stückzahlen, beispielsweise in Spritzgusstechnik kostengünstig herstellen.

Für die Bündelung der Lichtstrahlen in eine gewünschte Strahlrichtung kann der Reflektor beispielsweise als sphärischer Konkavspiegel oder als Parabolidspiegel ausgebildet sein, in dessen Brennebene ein zugeordnetes, lichtemittierendes Halbleiterbauelement angeordnet ist.

Eine kostengünstige Ausführung mit effizienter Wärmeabfuhr kann so ausgeführt sein, dass das Trägerteil eine Leiterplatte ist, auf der die Halbleiterbauelemente, - gesehen in einer Sicht durch die Ebene der Leiterplatte hindurch -, jeweils gleich beabstandet angeordnet sind. Der Versatz zwischen den Bauelementen auf der Vorderseite und denen auf der Rückseite begünstigt den Wärmetransport auf den Kühlkörper der jeweils gegenüberliegenden Seite des Trägerteils.

Der Wärmetransport durch die Leiterplatte hindurch kann mit Vorteil als thermische Durchkontaktierung, sogenannte "thermal vias" ausgebildet sein. Diese "thermal vias" bestehen aus mit Lot gefüllten Bohrungen und werden im Herstellungsprozess einer Leiterplatte weitgehend wie elektrische Durchkontaktierungen gehandhabt. Sie liegen mit einem Ende am Halbleiterbauelement an und sind am anderen Ende mit einer wärmeleitenden Schicht verbunden, die auf der gegenüberliegenden Hauptfläche des Trägerteils ausgebildet ist. Die wärmeleitende Schicht kann z.B. eine Cu-Schicht sein.

Hinsichtlich eines geringen Gewichts ist es günstig, wenn jeder Kühlkörper als Formkörper ausgebildet ist, der Abstützteile aufweist, die in einem zusammengebauten Zustand jeweils auf einer dieser wärmeleitenden Schichten abgestürzt sind.

Ein besonders kompakter Aufbau lässt sich erreichen, wenn die Halbleiterbauelemente in Oberflächenmontage auf den Hauptflächen des Trägerteils montiert sind.

Eine gute thermische Entkopplung zwischen LED's auf der Vorder- und Rückseite lässt sich dadurch erreichen, indem jedes auf einer der Hauptflächen montierte Halbleiterbauelement durch einen Ringspalt von dem dieser Hauptfläche zugewandten Kühlkörper beabstandet ist. Wenn die LED's der Vorder- und Rückseite nicht gleichzeitig betrieben werden, ist dadurch die Betriebstemperatur geringer.

Für eine Blinkleuchte bei einem KFZ kann eine Beleuchtungseinrichtung vorteilhaft sein, bei der an jedem der Kühlkörper mehrere Reflektoren so ausgebildet sind, dass sich benachbarte Strahlungscharakteristik überlappt.

Hinsichtlich der Wärmeabfuhr kann es vorteilhaft sein, wenn bei einem Kühlkörper der Reflektor und die Kühlrippen materialeinheitlich ausgebildet sind und die Kühlrippen in Strahlungsrichtung sich erstrecken.

Je nach gewünschter Lichtintensität kann eine unterschiedliche Anzahl von LED's auf der Vorder- bzw. - Rückseite des Trägerteils vorteilhaft sein.

### Kurzbeschreibung der Zeichnungen

Zur weiteren Erläuterung der Erfindung wird im nachfolgenden Teil der Beschreibung auf die Zeichnungen Bezug genommen aus denen weitere vorteilhafte Ausgestaltungen, Einzelheiten und Weiterbildungen der Erfindung zu entnehmen sind.
Es zeigen:
- Figur 1: eine erfindungsgemäße Beleuchtungseinheit in einem zusammengebauten Zustand in einer Vorderansicht;
- Figur 2: eine erfindungsgemäße Beleuchtungseinheit in einem zusammengebauten Zustand in einer Rückansicht;
- Figur 3: die erfindungsgemäße Beleuchtungseinheit, gesehen von oben;

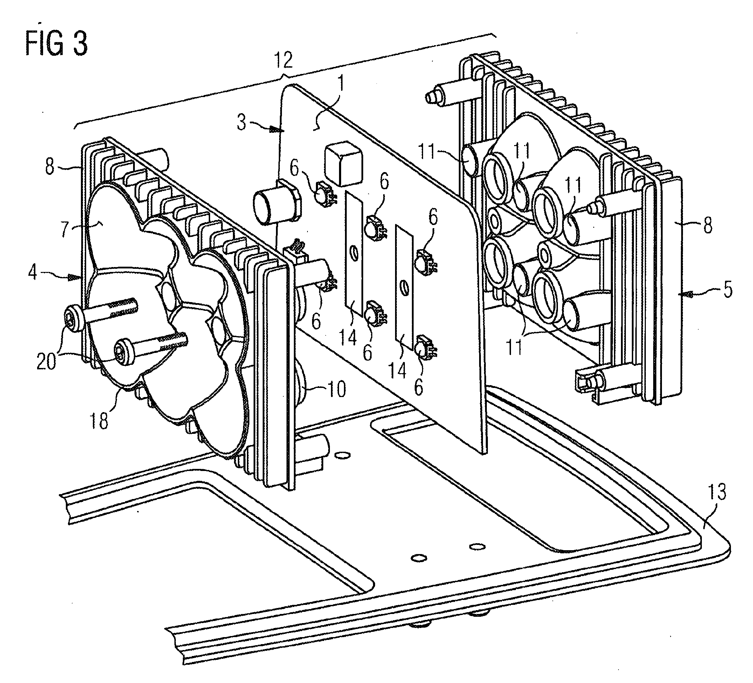

- Figur 3: die erfindungsgemäße Beleuchtungseinheit, dargestellt in einer Explosionszeichnung, gesehen von schräg unten;

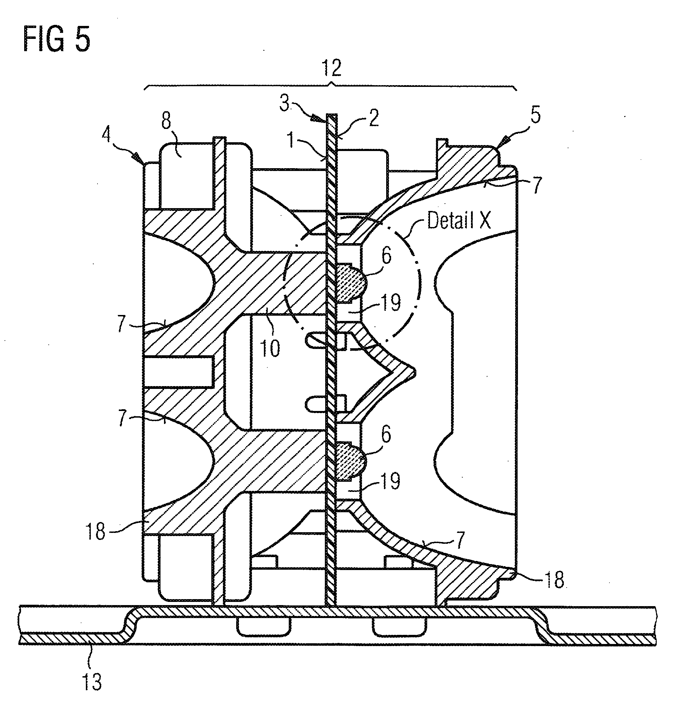

- Figur 5: die erfindungsgemäße Beleuchtungseinheit in einer Schnittzeichnung;

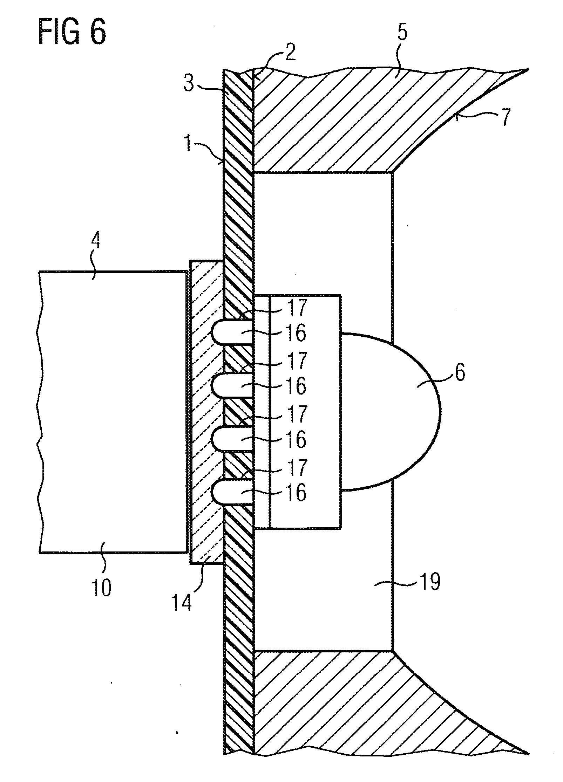

- Figur 6: eine vergrößerte Darstellung des Details X der Figur 5.

### Ausführung der Erfindung

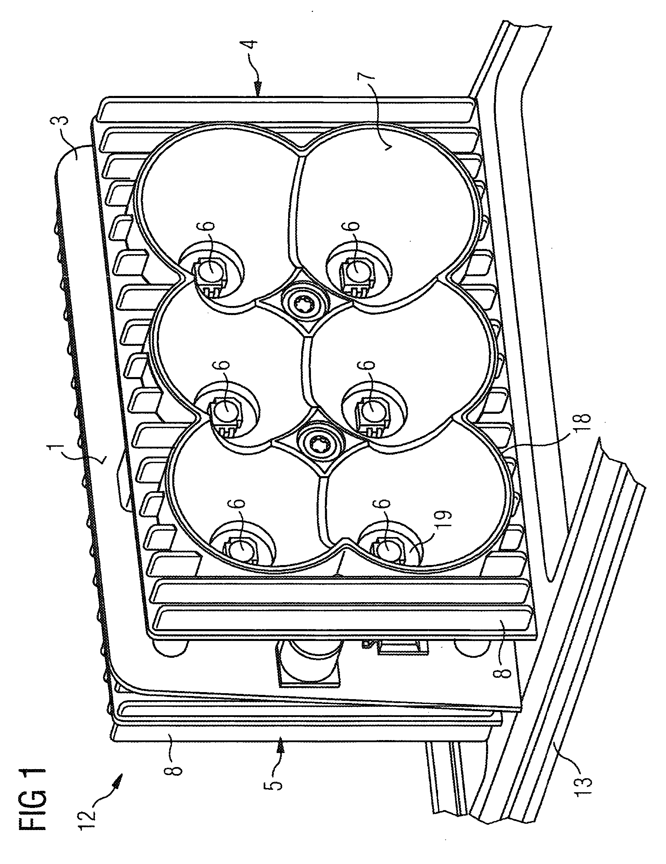

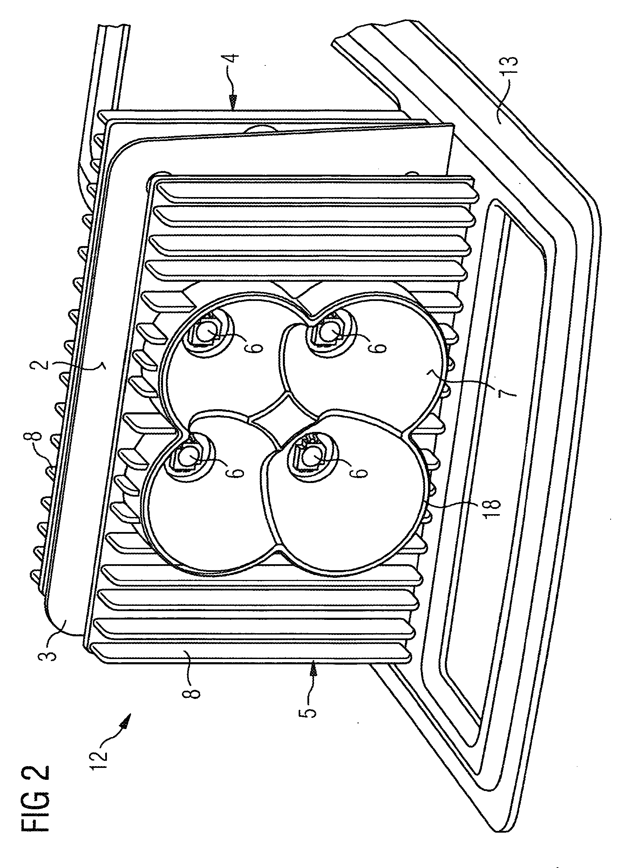

Die Figur 1 und die Figur 2 zeigt ein Ausführungsbeispiel der erfindungsgemäßen Beleuchtungseinrichtung in einer räumlichen Darstellung als Vorder- bzw. Rückansicht. Die Beleuchtungseinrichtung ist insgesamt mit dem Bezugszeichen 12 gekennzeichnet. Sie besteht im vorliegenden Beispiel im Wesentlichen aus einer Leiterplatte 3, die beidseitig mit Hochleistungs-Leuchtdioden 6 bestückt ist und nach Art eines Sandwichs zwischen zwei Kühlkörper 4,5 mittels Befestigungsschrauben 20 zusammengehalten ist. Jeder Kühlkörper besitzt Kühlrippen 8. Diese Kühlrippen 8 zeigen jeweils in Strahlungsrichtung der Reflektoren 18, die an jedem Kühlkörper 4 bzw. 5 ausgebildet sind. Der Kühlkörper 4 bzw. 5 bildet mit dem jeweiligen Reflektor 18 eine bauliche Einheit, welche jeweils die Doppelfunktion der Wärmeableitung und der Lichtstrahl-Lenkung erfüllt. Die Kühlkörper 4 bzw. 5 sind in diesem Beispiel als Spritzgussformkörper aus einem Metall hergestellt und auf einem Gestell 13 angeordnet.

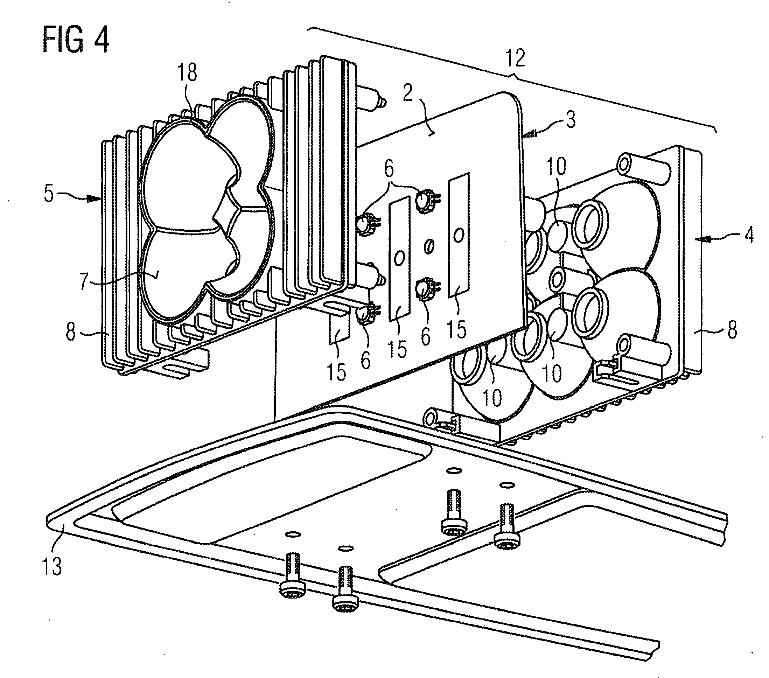

Wie am besten aus der auseinander gezogenen Darstellung der Figur 3 bzw. der Figur 4 zu erkennen ist, weist jeder Kühlkörper 4,5 jeweils ein Abstützteil 10 bzw. 11 auf. Jedes dieser Abstützteile 10 bzw. 11 diente zur Entwärmung der jeweils gegenüberliegenden Hochleistungs-Leuchtdiode, was im Folgenden näher erläutert ist:

In einem zusammengebauten Zustand kommt jedes Abstützteil 10 des Kühlkörpers 4 mit einer Wärmeleitfläche 14, im vorliegenden Fall eine Cu-Schicht, in Berührung, die auf der Hauptfläche 1 der Leiterplatte 3 ausgebildet ist.
Wie aus Figur 3 leicht zu ersehen ist, befinden sich auf der Hauptfläche 1 zwei dieser wärmeleitenden Schichten 14. Die wärmeleitenden Schichten 14 sind wiederum mit den vier auf der zweiten Hauptfläche 2 (siehe Figur 4) der Leiterplatte 3 angeordneten vier Hochleistungs-Leuchtdioden 6 durch "thermal vias" gut wärmeleitend verbunden. Auf diese Weise wird die bei Betrieb der vier LED's anfallende Wärme zum Kühlkörper 4, der der ersten Hauptfläche 1 zugewandt ist, übertragen und von dort an den Außenraum abgeleitet.

Dementsprechend kommt in einem zusammengebauten Zustand jedes Abstützteil 11 des rückwärtigen Kühlkörpers 5 mit einer Wärmeleitfläche 15, die am besten aus Figur 4 zu erkennen ist, zur Anlage. Die wärmeleitende Schicht 15 ist wieder eine Cu-Schicht die in an sich bekannter Weise auf der zweiten Hauptfläche 2 der Leiterplatte 3 ausgebildet ist. Auf der Rückseite 2 sind drei dieser wärmeleitenden Schichten 15 ausgebildet. Jede dieser Schichten 15 ist jeweils mit einem Paar der sechs Hochleistungs-Leuchtdioden 6 (siehe Figur 3) auf der Vorderseite 1 der Leiterplatte 3 thermisch verbunden. Die thermische Verbindung erfolgt wieder durch sogenannte "thermal vias". In einem zusammengebauten Zustand werden diese sechs, auf der Vorderseite 1 der Leiterplatte 3 angeordneten Hochleistungs-Leuchtdioden 6 vom rückwärtigen Kühlkörper 5 entwärmt.

Mit anderen Worten ausgedrückt, jede Hochleistungs-Leuchtdiode der einen Seite, wird von einem, auf der anderen Seite angeordneten Kühlkörper entwärmt, der gleichzeitig Reflektor für LED's ist, die auf der ihm zugewandten Hauptfläche angeordnet sind.

Dieses erfindungsgemäße Entwärmungskonzept ist in Figur 5 in einer Schnittzeichnung dargestellt. Die Zeichnung zeigt im Schnitt zwei Hochleistungs-Leuchtdioden 6 auf der zweiten Hauptfläche 2 der Leiterplatte 3. Die anfallende elektrische Verlustleistung wird durch die Leiterplatte 3 hindurch (siehe Detail X der Figur 6) auf ein dahinter liegendes Abstützteil 10 des Kühl-Formkörpers 4 übertragen, dessen Oberfläche die Wärme an die Umgebungsluft abgibt.

In der Figur 6 ist das Detail X der Figur 5 vergrößert dargestellt. Die LED 6 ist in Oberflächenmontage auf der zweiten Hauptfläche 2 der Leiterplatte 3 gelötet. Die Leiterplatte 3 weist mehrere als Bohrungen ausgebildete Durchbrechungen 17 auf. Diese Bohrungen 17 sind mit Lot gefüllt und bilden eine thermische Durchkontaktierung 16. Mit ihrer Rückseite liegt die LED 6 an diesen metallisch gefüllten Durchkontaktierungen 16 an, wodurch die bei Betrieb in der LED 6 erzeugte Wärme nach rückwärts zunächst auf die wärmeleitende Cu-Schicht 14 geleitet wird. Auf der wärmeleitenden Schicht 14 ist ein Abstützteil 10 eines Kühlkörper 4 abgestützt, der die in der LED 6 erzeugte Wärme ableitet. Wie bereits eingangs erwähnt, ist anstelle der thermischen Durchkontaktierung 16 auch ein metallisches Einlegeteil in einem Durchbruch der Leiterplatte 3 denkbar.

Zum Zwecke der thermischen Entkopplung ist zwischen der LED 6 und dem Kühlkörper 5, der der zweiten Hauptfläche 2 zugewandt sind, ein Ringspalt 19 ausgebildet. Ein entsprechender Ringspalt 19 ist auch zwischen den LED's auf der ersten Hauptfläche 1 und dem Kühlkörper 4 ausgebildet (Figur 1).

### Zusammenstellung der verwendeten Bezugszeichen

- 1: erste Hauptfläche
- 2: zweite Hauptfläche
- 3: Trägerteil
- 4: Kühlkörper auf 1
- 5: Kühlkörper auf 2
- 6: Hochleistungs-Leuchtdiode (LED)
- 7: reflektierende Oberfläche
- 8: Kühlrippen
- 9:
- 10: Abstützteil
- 11: Abstützteil
- 12: Beleuchtungseinheit
- 13: Gestell
- 14: wärmeleitende Schicht auf 1
- 15: wärmeleitende Schicht auf 2
- 16: thermische Durchkontaktierung
- 17: Durchbrechung
- 18: Reflektor
- 19: Spalt
- 20: Befestigungsschrauben

## Patentansprüche

1. Beleuchtungseinheit mit einem flächenförmigen Trägerteil (3), auf dem beidseitig jeweils auf einer Hauptfläche (1,2) eine Mehrzahl von lichtemittierenden Halbleiterbauelementen (6), insbesondere Hochleistungs-Leuchtdioden, angeordnet sind, und auf jeder Seite des Trägerteils (3) jeweils ein Kühlkörper (4,5) vorgesehen ist, **dadurch gekennzeichnet,**
- **dass** jedes der Halbleiterbauelemente (6) mittels eines Wärmeleitmittels (16), das durch eine Durchbrechung (17) des Trägerteils (3) hindurchgeführt ist, gut wärmeleitend mit einem auf der gegenüberliegenden Seite des Trägerteils (3) vorgesehenen Kühlkörper (4,5) verbunden ist, und
- **dass** an jedem Kühlkörper (4,5) zumindest ein Reflektor (18) ausgebildet ist, der eine reflektierende Oberfläche (7) aufweist, welche die Lichtemission eines Halbleiterbauelementes (6) bündelt, welches auf der diesem Kühlkörper zugewandten Seite des Trägerteils (3) angeordnet ist.

2. Beleuchtungseinheit nach Anspruch 1, **dadurch gekennzeichnet, dass** jedem der auf einer Hauptfläche (1,2) angeordneten Halbleiterbauelemente (6) jeweils ein Reflektor (18) zugeordnet ist, der an einem dieser Hauptfläche zugewandten Kühlkörper (4,5) ausgebildet ist.

3. Beleuchtungseinheit nach Anspruch 1 oder 2, **dadurch gekennzeichnet, dass** jeder an einem der Kühlkörper (4,5) ausgebildete Reflektor (18) mit diesem Kühlkörper einstückig und materialeinheitlich aus einem metallischen Werkstoff hergestellt ist.

4. Beleuchtungseinheit nach Anspruch 3, **dadurch gekennzeichnet, dass** jeder Reflektor (18) als Teil eines sphärischen Konkavspiegels ausgebildet ist, in dessen Brennebene ein zugeordnetes Halbleiterbauelement (6) angeordnet ist.

5. Beleuchtungseinheit nach Anspruch 4, **dadurch gekennzeichnet, dass** an jedem der Kühlkörper (4,5) mehrere Reflektoren (18) so ausgebildet sind, dass sich eine benachbarte Strahlungscharakteristik überlappt.

6. Beleuchtungseinrichtung nach einem der Ansprüche 2 bis 5, **dadurch gekennzeichnet, dass** das Trägerteil (3) eine Leiterplatte ist, auf der die Halbleiterbauelemente (6), gesehen in einer Sicht durch die Ebene der Leiterplatte hindurch, gleich beabstandet angeordnet sind.

7. Beleuchtungseinheit nach Anspruch 6, **dadurch gekennzeichnet, dass** das Wärmeleitmittel als thermische Durchkontaktierungen (16) ausgebildet ist, welche jeweils an einem Ende mit einem Halbleiterbauelement (6) und am gegenüberliegenden Ende mit einer wärmeleitenden Schicht (14,15), die auf der, diesem Halbleiterbauelement (6) gegenüberliegenden Hauptfläche des Trägerteils (3) ausgebildet ist, verbunden ist.

8. Beleuchtungseinheit nach Anspruch 7, **dadurch gekennzeichnet, dass** in einem zusammengebauten Zustand auf jeder wärmeleitenden Schicht (14,15) jeweils zumindest ein Abstützteil (10,11) eines einer Schicht (14,15) zugewandten Kühlkörpers (4,5) abgestüzt ist.

9. Beleuchtungseinheit nach Anspruch 8, **dadurch gekennzeichnet, dass** die Halbleiterbauelemente (6) in Oberflächenmontage auf den Hauptflächen (1,2) des Trägerteils (3) montiert sind.

10. Beleuchtungseinheit nach Anspruch 9, **dadurch gekennzeichnet, dass** jedes der auf einer Hauptfläche (1,2) montierten Halbleiterbauelemente (6) jeweils durch einen Spalt (19) von dem dieser Hauptfläche (1,2) zugewandten Kühlkörper (4,5) beabstandet ist.

11. Beleuchtungseinheit nach Anspruch 10, **dadurch gekennzeichnet, dass** jeder Kühlkörper (4,5) Kühlrippen (8) aufweist.

12. Beleuchtungseinheit nach Anspruch 10, **dadurch gekennzeichnet, dass** die Anzahl der Halbleiterbauelemente (6) auf der ersten Hauptfläche (1) unterschiedliche zur Anzahl der Halbleitebauelemente (6) auf der zweiten Hauptfläche (2) ist.

## Claims

1. Illumination unit with a planar carrier part (3) having a plurality of light-emitting semiconductor components (6), in particular high-power light-emitting diodes, arranged on each of the two sides on a main surface (1,2), wherein a heat sink (4,5) is provided on each side of the carrier part (3), **characterised in that**,
- each of the semiconductor components (6) is connected in an efficient heat-conducting manner to a heat sink (4,5) provided on an opposite side of the carrier part (3) by way of a heat conducting means (16) that is fed through an opening (17) in the carrier part (3) and
- on each heat sink (4,5) at least one reflector (18) is embodied having a reflective surface (7) which concentrates the light emitted from a semiconductor component (6) which is arranged on the side of the carrier part (3) facing this heat sink.

2. Illumination unit according to claim 1, **characterised in that** a reflector (18) is assigned to each of the semiconductor components (6) arranged on a main surface (1,2) which is embodied on one of these heat sinks (4,5) facing this main surface.

3. Illumination unit according to claim 1 or 2, **characterised in that** each reflector (18) embodied on one of these heat sinks (4,5) is manufactured in one piece from the same material as said heat sink and is made of a metallic material.

4. Illumination unit according to claim 3, **characterised in that** each reflector (18) is embodied as part of a spherical concave mirror with an assigned semiconductor component (6) arranged in its focal plane.

5. Illumination unit according to claim 4, **characterised in that** several reflectors (18) are embodied on each of these heat sinks (4,5) so that a neighbouring radiation pattern overlaps.

6. Illumination unit according to one of claims 2 to 5, **characterised in that** the carrier part (3) is a printed circuit board, on which the semiconductor components (6) are arranged equidistantly, viewed through the plane of the printed circuit board.

7. Illumination unit according to claim 6, **characterised in that** the heat conducting means is embodied as a thermal via (16) which is connected at one end to a semiconductor component (6) and at the opposite end to a heat-conducting layer (14,15) embodied on the main surface of the carrier part (3) lying opposite said semiconductor component (6).

8. Illumination unit according to claim 7, **characterised in that** in an assembled state on each heat-conducting layer (14,15) at least one support (10,11) of a heat sink (4,5) facing a layer (14, 15) is supported in each case.

9. Illumination unit according to claim 8, **characterised in that** the semiconductor components (6) are mounted by surface mounting on the main surfaces (1,2) of the carrier part (3).

10. Illumination unit according to claim 9, **characterised in that** each of the semiconductor components (6) mounted on a main surface (1,2) is distanced from the heat sink (4,5) facing this main surface (1,2) by a clearance (19) in each case.

11. Illumination unit according to claim 10, **characterised in that** each heat sink (4,5) has cooling fins (8).

12. Illumination unit according to claim 10, **characterised in that** the number of semiconductor components (6) on the first main surface (1) is different from the number of semiconductor components (6) on the second main surface (2).

## Revendications

1. Unité d'éclairage comprenant une pièce support (3) de forme plane sur laquelle est disposée des deux côtés, sur une surface principale (1, 2), une pluralité de composants semi-conducteurs (6) émettant de la lumière, en particulier des diodes électroluminescentes à haute puissance, et de chaque coté de ladite pièce support (3) est prévu un radiateur (4, 5), **caractérisée en ce que**
- par l'intermédiaire d'un moyen thermoconducteur (16) guidé à travers une rupture (17) de la pièce support (3), chacun des composants semi-conducteurs (6) est relié avec une bonne conduction thermique à un radiateur (4, 5) prévu sur le côté opposé de la pièce support (3), et
- sur chaque radiateur (4, 5) est réalisé au moins un réflecteur (18) qui possède une surface réfléchissante (7), laquelle focalise l'émission de lumière d'un composant semi-conducteur (6) disposé sur le côté faisant face audit radiateur de la pièce support (3).

2. Unité d'éclairage selon la revendication 1, **caractérisée en ce qu'**à chacun des composants semi-conducteurs (6) disposés sur une surface principale (1, 2) est associé un réflecteur (18), lequel est réalisé sur un radiateur (4, 5) faisant face à ladite surface principale.

3. Unité d'éclairage selon la revendication 1 ou 2, **caractérisée en ce que** chaque réflecteur (18) réalisé sur l'un des radiateurs (4, 5) est fabriqué en une seule pièce avec ledit radiateur et de manière homogène à partir d'un même matériau métallique.

4. Unité d'éclairage selon la revendication 3, **caractérisée en ce que** chaque réflecteur (18) est réalisé en tant que partie d'un miroir concave sphérique dans le plan focal duquel est disposé un composant semi-conducteur (6) associé.

5. Unité d'éclairage selon la revendication 4, **caractérisée en ce que** plusieurs réflecteurs (18) sont réalisés sur chacun des radiateurs (4, 5), de sorte qu'il y a chevauchement d'une caractéristique de rayonnement voisine.

6. Unité d'éclairage selon l'une des revendications 2 à 5, **caractérisée en ce que** la pièce support (3) est une carte de circuit imprimé sur laquelle les composants semi-conducteurs (6), vus à travers le plan de ladite carte, sont disposés à distance égale.

7. Unité d'éclairage selon la revendication 6, **caractérisée en ce que** ledit moyen thermoconducteur est conçu sous forme de contact traversant thermique (16), relié à une extrémité à un composant semi-conducteur (6) et à l'extrémité opposée à une couche thermoconductrice (14, 15) réalisée sur la surface principale en regard dudit composant semi-conducteur (6) de la pièce support (3).

8. Unité d'éclairage selon la revendication 7, **caractérisée en ce qu'**à l'état assemblé, sur chaque couche thermoconductrice (14, 15), au moins une pièce d'appui (10, 11) d'un radiateur (4, 5) faisant face à une couche (14, 15) est en appui.

9. Unité d'éclairage selon la revendication 8, **caractérisée en ce que** les composants semi-conducteurs (6) sont montés sur les surfaces principales (1, 2) de la pièce support (3) selon la technique de montage en surface.

10. Unité d'éclairage selon la revendication 9, **caractérisée en ce que** chacun des composants semi-conducteurs (6) montés sur une surface principale (1, 2) est séparé du radiateur (4, 5) faisant face à ladite surface principale (1, 2) par un espace (19).

11. Unité d'éclairage selon la revendication 10, **caractérisée en ce que** chaque radiateur (4, 5) a des ailettes de refroidissement (8).

12. Unité d'éclairage selon la revendication 10, **caractérisée en ce que** le nombre de composants semi-conducteurs (6) sur la première surface principale (1) est différent du nombre de composants semi-conducteurs (6) sur la deuxième surface principale (2).
